(19) **Europäisches Patentamt / European Patent Office / Office européen des brevets**

(11) **EP 3 918 013 B1**

(12) **EUROPEAN PATENT SPECIFICATION**

(45) Date of publication and mention
of the grant of the patent:
**23.08.2023 Bulletin 2023/34**

(21) Application number: **19700907.9**

(22) Date of filing: **15.01.2019**

(51) International Patent Classification (IPC):
**C09D 11/38** [(2014.01)] **C09D 11/322** [(2014.01)]
**C09D 11/36** [(2014.01)] **H03K 3/10** [(2006.01)]
**H05K 1/09** [(2006.01)]

(52) Cooperative Patent Classification (CPC):
**C09D 11/36; C09D 11/322; C09D 11/38;**
**H10K 71/15;** H10K 30/151; Y02E 10/549

(86) International application number:
**PCT/EP2019/050965**

(87) International publication number:
**WO 2020/147939 (23.07.2020 Gazette 2020/30)**

(54) **INK FORMULATION FOR INKJET PRINTING OF PEROVSKITE ACTIVE LAYERS**

TINTENFORMULIERUNG FÜR TINTENSTRAHLDRUCK VON PEROWSKIT-AKTIVSCHICHTEN

FORMULATION D'ENCRE POUR IMPRESSION À JET D'ENCRE DE COUCHES ACTIVES DE PÉROVSKITE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**08.12.2021 Bulletin 2021/49**

(73) Proprietor: **Toyota Motor Europe**
**1140 Brussels (BE)**

(72) Inventors:
• **KINGE, Sachin**
**1140 BRUSSELS (BE)**
• **HUCKABA, Aron, J.**
**1015 LAUSANNE (CH)**
• **NAZEERUDDIN, Mohammad, Khaja**
**1015 LAUSANNE (CH)**

(74) Representative: **Cabinet Beau de Loménie**
**158, rue de l'Université**
**75340 Paris Cedex 07 (FR)**

(56) References cited:
EP-A1- 3 223 323        EP-A1- 3 279 960
WO-A2-2017/158551        TW-A- 201 709 540
US-A1- 2018 105 543

• HABIBI MEHRAN ET AL: "Progress in emerging solution-processed thin film solar cells - Part II: Perovskite solar cells", RENEWABLE AND SUSTAINABLE ENERGY REVIEWS, ELSEVIERS SCIENCE, NEW YORK, NY, US, vol. 62, 19 May 2016 (2016-05-19), pages 1012-1031, XP029599789, ISSN: 1364-0321, DOI: 10.1016/J.RSER.2016.05.042
• SHAO-GANG LI ET AL: "Inkjet printing of CH 3 NH 3 PbI 3 on a mesoscopic TiO 2 film for highly efficient perovskite solar cells", JOURNAL OF MATERIALS CHEMISTRY A, vol. 3, no. 17, 1 January 2015 (2015-01-01), pages 9092-9097, XP055372357, GB ISSN: 2050-7488, DOI: 10.1039/C4TA05675B cited in the application

## Description

Field of the Invention

The present invention is in the field of materials for optoelectronic applications and in particular solar cells and light emitting diodes (LEDs).

Background to the Invention

In the technical field of optoelectronic devices, it is often required to prepare thin films of semiconducting materials. This is because creating films of uniform property and thickness is crucial for applications for large-area and flexible devices. The industrially scalable methods of spray coating, ink jet printing can be applied for this purpose but appropriate inks are needed.

Inkjet printing is a material-conserving deposition technique used for liquid inks, which consist of a material to be deposited, dissolved or dispersed in a solvent. The inkjet printing process consists in ejecting a given amount of ink in a chamber from a nozzle via piezoelectric action. The ejected drop falls on a substrate and spreads, and then dries through solvent evaporation. Inkjet printing offers a possibility of direct imaging, and thus provides more flexibility in designing optoelectronic devices.

Among several semiconducting materials, perovskites have received a lot of attention in recent years due to their flexibility, low weight and low cost.

Perovskites $RMX_3$ (wherein R is an organic group such as methyl, butyl, phenyl etc., M are metal cations of Pb, Cs, and X are halide ions such as I, Cl, Br) are materials that are important for solar cells, LEDs and several optoelectronic applications, since these materials can be prepared as 2D or 3D materials. These materials have so far been used as bulk materials.

Studies have been performed on preparation of perovskite thin films by inkjet printing technology, for use in optoelectronic devices.

*Mathies et al.* discloses ((1) multipass inkjet-printed perovskite solar cell preparation, wherein after printing with an ink composition comprising gamma-butyrolactone (GBL) and DMSO at a ratio of 7 to 3 (binary blend), a flow of nitrogen is used during annealing to keep away oxygen and moisture during perovskite crystallization. The ink composition gives a coffee ring effect upon drying and/or film annealing. The thus obtained perovskite film has a Power Conversion Efficiency (PCE) of 11.3%.

*Abzieher et al.* ([2]) discloses perovskite ($CH_3NH_3PbI_3$) layers prepared by thermal evaporation of lead iodide, a subsequent solution-based conversion and annealing in ambient atmosphere. The ink composition used in this disclosure comprises methyammonium iodide and hydrophosphorous acid. After printing, the film was annealed under ambient atmosphere. The improved morphology results in an overall increase in power conversion efficiency from 5.1% to 8.0%. Here, the use of vacuum deposited $PbI_2$ and the use of hydrophosphorous acid (HPA) results in low efficiencies of corresponding photovoltaic devices. Thus obtained perovskite film has a Power Conversion Efficiency (PCE) of 11.3%.

*Shao-Gang et al.* ([3]) discloses deposition of a flat and uniform perovskite $CH_3NH_3PbI_3$ layer on a mesoscopic $TiO_2$ film. The ink composition used in this disclosure is a binary anion (I/Cl) mixture in a single solvent (gamma-butyrolactone), which resulted in large crystal growth upon thermal annealing. The corresponding photovoltaic device exhibits a high efficiency of 12.3% with an average value of 11.2% under AM 1.5G conditions.

*Mathies et al.* ([4]) discloses triple cation perovskite layers deposited with 10% cesium in a mixed formamidinium/methylammonium lead iodide/bromide composites for solar cell with temperature and moisture stability.

However, these prior art disclosure systems had some inconvenient points: the methods were not scalable and not reproducible, and it was not possible to ensure uniform drying across the area of the printed film or to produce films of uniform property and thickness. Further, the previously disclosed methods were not simple to use, since the step of annealing had to be carried out in a glovebox atmosphere and not under ambient conditions.

Patent publications EP 3 223 323 and WO 2017/158551 describe perovskite precursors prepared in a solvent mixture containing DMF, GBL and DMSO, applied in the fabrication of a solar cell by a spin coating procedure. Non-Patent Literature Reference [5] is a general review of perovskite solar cell manufacturing techniques and, like patent publication US 2018/0105543, describes different solvents that could be used for coating with perovskites. EP 3 279 960 describes inkjet printing compositions containing perovskites, using experimentally the single solvent gamma-butyrolactone. Patent publication TW 2017-09540 uses the single solvent DMF or a combination of DMSO and GBL for spin coating of perovskites.

Non-Patent Literature References

[1] J. Mater. Chem. A. 2016, 4, 19207

[2] Phys. Status Solidi A, 214, 1700509

[3] J. Mater. Chem. A. 2015, 3(17), 9092

[4] ACSAppl. Energy Mater. 2018, 1, 5, 1834-1839

[5] Habibi et al., Renewable and Sustainable Energy Reviews, 62, 2016, 1012-1031

Summary of the Invention

The present invention aims at providing a composition which enables one to create films of uniform property and thickness, and to ensure reproducible fabrication of high quality perovskite films outside of a glovebox and in ambient conditions, as well as stable inkjet printing at a variety of cartridge and substrate temperatures, from 21 °C to 50 °C, reducing the "coffee ring" effect upon ink drying/concentration.

The present ink formulation is intended for reproducible fabrication of high quality perovskite films using scalable processing techniques, which has been a problem for previous reports of inkjet-printed perovskite films.

In one aspect, the present invention also relates to a method for inkjet printing of perovskite precursor solution on a variety of substrates including flexible substrates.

The present invention relates to a composition comprising:

(A) at least one perovskite precursor(s); and

(B) a mixture of solvents as defined in appended claim 1.

The present invention also relates to a method for inkjet-printing the composition of the present invention, as well as its use and a solar cell comprising the composition of the present invention.

In another aspect, the present invention also relates to a method of inkjet printing comprising the following steps:

(1) printing the composition of the invention on a substrate to obtain a printed film;

(2) dipping the printed film obtained in step (1) in an anti-solvent, to obtained a dipped film; and

(3) annealing the dipped film obtained in step (2).

In still another aspect, the present invention also relates to a use of the composition according to the present invention.

In still another aspect, the present invention also relates to a solar cell wherein the composition according to the present invention and a composition comprising $TiO_2$ are inkjet-printed.

Brief Description of the Figures

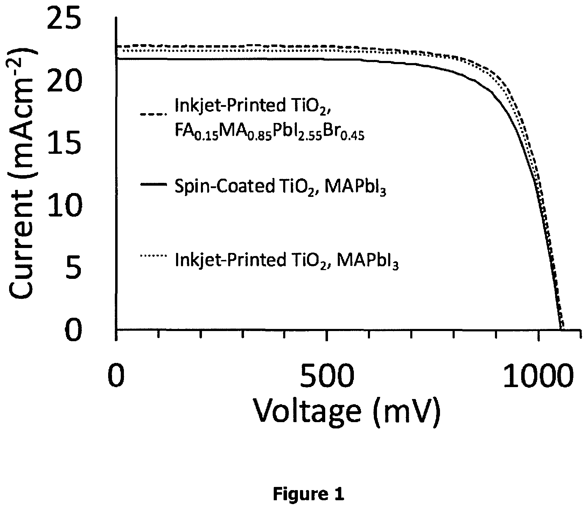

Figure 1 presents J-V (current-voltage) curves, showing the fill factor, Jsc and Voc of the devices, of cells using a) spin-coated $TiO_2$ and $MAPbI_3$, b) inkjet-printed mesoporous $TiO_2$ and $MAPbI_3$ and c) inkjet-printed $(FA_{0.15} MA_{0.85})Pb(I_{2.55}Br_{0.45})$.

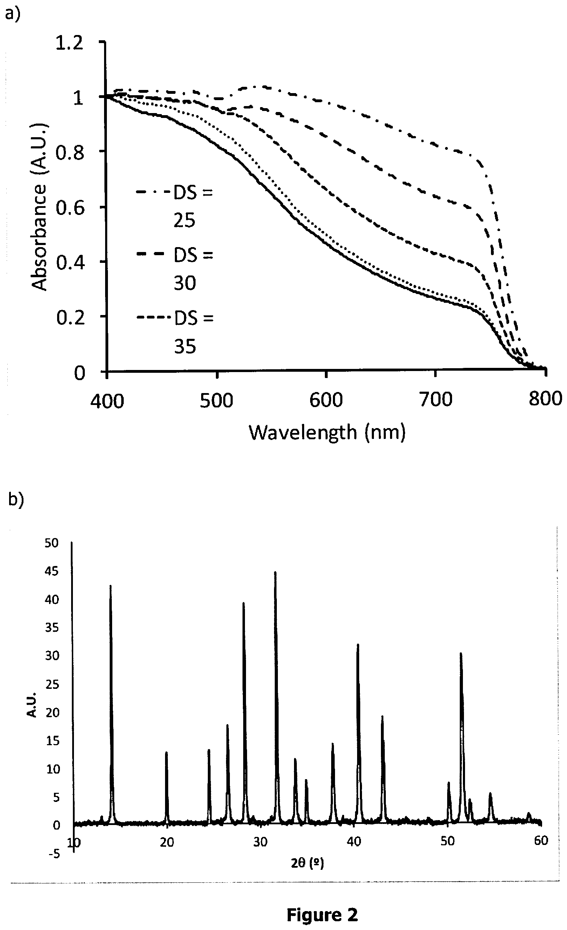

Figure 2 presents a) UV-Vis-NIR absorption spectrum of inkjet-printed perovskite films on inkjet-printed $TiO_2$ films with varying drop spacing values, and b) power X-Ray Diffraction pattern of the inkjet-printed perovskite film on inkjet-printed $TiO_2$.

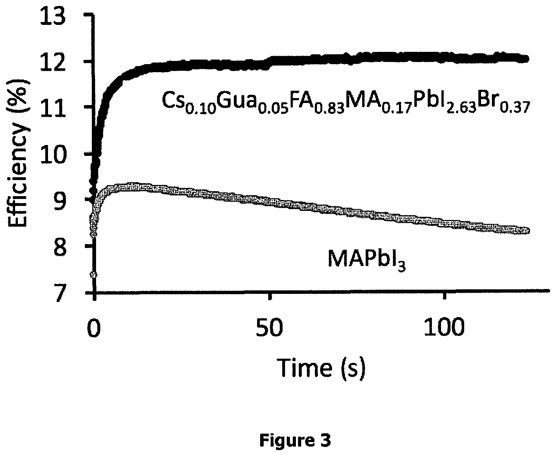

Figure 3 presents a continuous power output measurement of a typical quadruple cation perovskite solar cell of the present invention, compared to a similarly prepared device with $MAPbI_3$.

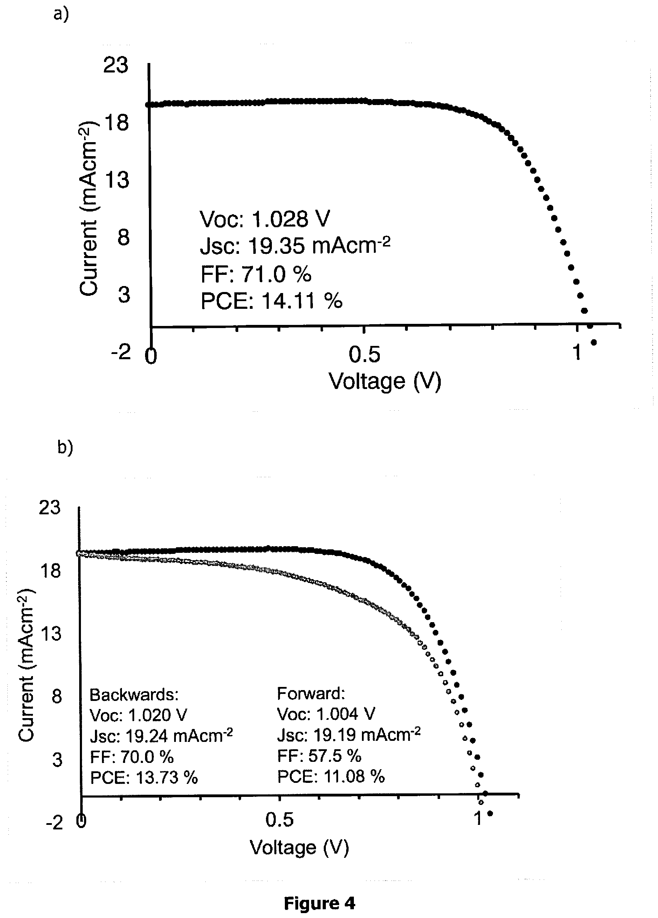

Figure 4 presents a) J-V curve of the best-performing cell described in Table 1 disclosed in the Example Section, illuminated with 100 $mWcm^{-2}$ of a simulated solar spectrum and b) backward and forward J-V scan.

Figure 5 presents a schematic structure of a typical solar cell using both $TiO_2$ and perovskite layers.

Detailed Description of the Invention

<Definitions>

The term "organic-inorganic hybrid perovskites", as used herein, refers to $ABX_3$ materials with A = cation groups such as methylammonium (MA), butylammonium (BA), formamidinium (FA), Cs, and their mixtures; M is a metal such as Pb, Sn, Bi, Cu, Ag and their mixtures; and X are halides such as Cl, Br, I and their mixtures. Layered perovskites contain additional bulkier molecules such as phenethylamine (PEA) or phenyethylammonium, hexylammonium (HA) and longer chain ammonium species, which confine different perovskite domains into different repeating units. Specific examples given here comprise inorganic metal-halide multi-layered perovskites. These examples are nonlimiting.

The term "antisolvent", as used herein, refers to a solvent which precipitates the perovskite intermediate complex and induces nucleation while removing excess solvent. An anti-solvent treatment consists in, for example, introducing a volume of an anti-solvent, such as toluene, ethyl acetate, chlorobenzene, or ethyl ether onto the wet/drying/dry perovskite precursor film to supersaturate the precursor film and quickly induce nucleation and remove excess solvent to produce smooth perovskite films.

<Ink composition>

One aspect of the present invention relates to a composition comprising:

(A) at least one perovskite precursor(s); and
(B) a mixture of solvents comprising:

(B1) a lactone, an ester or a carbonate;
(B2) a linear N,N-dialkylamide;
(B3) a lactam; and
(B4) an alkyl sulfoxide.

(B3), a lactam, is preferably selected from the group consisting of N-alkyl lactams, and more preferably is N-methylpyrrolidone.

<Organic-inorganic perovskite precursors (A)>

The composition of the present invention comprises at least one perovskite precursor (A).

Perovskite precursors (A) used in the composition of the present invention are not particularly limited.

Preferably, perovskite precursors (A) can be selected from the group consisting of MAI, $PbI_2$, MABr, $PbBr_2$, MACl, $PbCl_2$, PEAI, PEABr, PEACl, CsI, $SrCl_2$, $CaCl_2$, KI, CsBr, CsCl, NaCl, NaI, GUAI, GUABr, GUACl, FAI, FABr, FACl, wherein MA stands for methylammonium, PEA for phenylethylammonium, GUA for guanidinium, and FA for formamidinium

More preferably, the at least one perovskite precursor(s) is (are) selected from the group consisting of $Pb^{2+}$, methylammonium, formamidium, guanidinium, cesium, iodide, bromide, chloride, acetate and thiocyanate ions.

Perovskite materials of particular interest in the present invention may be prepared starting with a metal halide, and in particular a lead halide such as lead chloride and/or lead bromide and/or lead iodide ($PbCl_2$, $PbBr_2$ or $PbI_2$), in combination with one or more ammonium salts such as methylammonium, phenylethylammonium.

In a particularly preferred embodiment, the perovskite precursors are $PbI_2$, methylammonium iodide and methylammonium chloride.

In one preferred embodiment, the combined concentration of all perovskite precursors (A) is 0.2 M or more and 0.4 M or less.

In a particularly preferred embodiment, component (A) of the ink composition of the invention consists of 0.6 M $PbI_2$, 0.6 M methylammonium iodide and 0.2 M methylammonium chloride.

In appropriate embodiments for any perovskite, the $PbI_2$ and MAI shall appropriately be stoichiometrically balanced in the precursor solution. The MACl is a crystallization-inducing additive. If the amount of the $PbI_2$ is less than the MAI in molar quantities, then the devices may be less reproducible. If the $PbI_2$ is stoichiometric or in slight excess, the devices may be expected to be more reproducible.

In one particularly preferred embodiment, the following perovskite precursors are used: $PbI_2$ (1.15 mmol, 0.53 g), FAI (formamidinium iodide) (1.033 mmol, 0.177 g), $PbBr_2$ (0.19 mmol, 0.071 g), MABr (0.18 mmol, 0.020 g), Guanidine iodide (GuI) (0.063 mmol, 0.012 g), and phosphatidylcholine (0.001 g).

The composition of the present invention also comprises at least one lactone, ester or a carbonate.

<Lactone (B1)>

Lactone (B1) used in the composition of the present invention is not particularly limited.

Preferably, lactone (B1) can be selected from the group consisting of gamma-butyrolactones optionally having one or more C1-C4 alkyl substituents on the carbon atoms of the ring.

More preferably, lactone (B1) is a non-substituted gamma-butyrolactone, which has desirable surface tension and viscosity while also being able to solvate the perovskite precursors.

<Ester (B1)>

Ester (B1) used in the composition of the present invention is not particularly limited.

Preferably, ester (B1) can be selected from the group consisting of benzyl benzoate, bis(2-ethylhexyl) adipate, bis(2-ethylhexyl) phthalate, 2-butoxyethanol acetate, butyl acetate, sec-butyl acetate, tert-butyl acetate, diethyl carbonate, dimethyl adipate, dioctyl terephthalate, ethyl acetate, ethyl acetoacetate, ethyl butyrate, ethyl lactate, ethylene carbonate, hexyl acetate, isoamyl acetate, isobutyl acetate, isopropyl acetate, methyl acetate, methyl lactate, methyl phenylacetate, methyl propionate, propyl acetate, propylene carbonate and triacetin.

<Carbonate (B1)>

Carbonate (B1) used in the composition of the present invention is not particularly limited.

Preferably, carbonate (B1) can be selected from the group consisting of dimethyl carbonate, diethylcarbonate, diphenyl carbonate, ethylene carbonate, and trimethylene carbonate.

<Linear N,N-dialkylamide (B2)>

Linear N-dialkylamide (B2) used in the composition of the present invention is not particularly limited.

Preferably, linear N-dialkylamide (B2) can be selected from the group consisting of N,N-dimethylformamide (DMF), N,N-diethylformamide (DEF), N,N-dimethylacetamide (DMAC) and N,N-diethylacetamide (DEAC).

Linear N,N-dialkylamide (b) is N,N-dimethylformamide, which has desirable surface tension and viscosity while also being able to solvate the perovskite precursors.

<Lactam (B3)>

The composition of the present invention further comprises a lactam (B3).

Lactam (B3) which can be used in the composition of the present invention is not particularly limited.

Lactam (B3) can be selected from the group consisting of N-alkyl lactams, propiolactam optionally substituted by alkyl substituents, caprolactam optionally substituted by alkyl substituents such as N-methyl caprolactam, and valerolactam optionally substituted by alkyl substituents such as N-methyl-2-piperidone, pyrrolidones (butyrolactams) and the mixtures thereof.

Preferably, lactam (B3) is N-methylpyrrolidone, which has desirable surface tension and viscosity while also being able to solvate the perovskite precursors.

When (B3) comprises N-methyl-2-pyrrolidone (NMP) in low quantities, for example in an amount of 0.1 to 15% by weight with respect to the total weight of the ink composition the inkjet composition has a good perovskite crystallization.

<Alkyl sulfoxide (B4)>

The present composition further comprises an alkyl sulfoxide (A4).

Alkyl sulfoxide (B4) is selected from the group consisting of dimethyl sulfoxide, cyclic or linear dialkyl sulfoxide, such as dimethyl sulfoxide, ethylmethyl sulfoxide, diethyl sulfoxide and other derivatives.

Preferably, alkyl sulfoxide (B4) is dimethyl sulfoxide.

It has been found that device performance can be enhanced with an alkyl sulfoxide.

<Combination of (B1), (B2), (B3) and (B4) >

Preferably, lactone (B1) is on substituted gamma-butyrolactone, linear N,N-dialkylamide (B2) is N,N-dimethylformamide, lactam (B3) is N-methylpyrrolidone, and (B4) is dimethyl sulfoxide. In such a case, the ink composition of the present invention has ink drying regularity, surface tension, and viscosity, and good solvation of perovskite precursors.

<Relative amount of (B1), (B2), (B4) and (B3) >

In terms of the relative amounts of the four solvents (B1), (B2), (B3) and (B4), preferably, for a total amount of added volume of solvents (B1), (B2), (B3) and (B4) summing to 100% by volume, the amount of (B1) is 30% by volume or more and 40% by volume or less, the amount of (B2) is 30% by volume or more and 40% by volume or less, the amount of (B3) is 0.01% by volume or more and 10% by volume or less and the amount of (B4) is 26% by volume or more and 30% by volume or less:

$$30 \leq \frac{volume \; of \; (B1)}{sum \; of \; the \; volume \; of \; (B1),(B2),(B3) \; and \; (B4)} * 100 \leq 40$$

$$30 \leq \frac{volume \; of \; (B2)}{sum \; of \; the \; volume \; of \; (B1),(B2),(B3) \; and \; (B4)} * 100 \leq 40$$

$$0.01 \leq \frac{volume \; of \; (B3)}{sum \; of \; the \; volume \; of \; (B1),(B2),(B3) \; and \; (B4)} * 100 \leq 10$$

$$26 \leq \frac{volume \; of \; (B4)}{sum \; of \; the \; volume \; of \; (B1),(B2),(B3) \; and \; (B4)} * 100 \leq 30$$

In the present invention, the added volumes of solvents (B1), (B2) and (B3) satisfy the relation: (B3) < (B4), (B4) < (B1) and (B4) < (B2).

In one preferred embodiment, (B) is a mixture consisting of (B1), (B2), (B3) and (B4) and the volume ratio between (B1), (B2), (B3) and (B4) is 33 : 33 : 5 : 28. In such a case, the ink composition of the present invention has ink drying regularity, surface tension, and viscosity, and good solvation of perovskite precursors.

In one particularly preferred embodiment, lactone (B1) is gamma-butyrolactone, linear N,N-dialkylamide (B2) is N,N-dimethylformamide and pyrrolidone (B3) is N-methylpyrrolidone, (B4) is dimethylsulfoxide, and the volume ratio between (B1), (B2), (B3) and (B4) is 33 : 33: 5 : 28.

In the present invention, when two or more liquids are mixed, the volume of the obtained mixture was substantially identical to the sum of the original separate solutions.

<Other additives>

The present composition can further comprise one or more additives, such as one or more surfactant(s), one or more dispersant(s) and Ti(acac)$_2$.

The one or more surfactant(s) can be, for example a zwitterionic surfactant, such as phosphatidylcholine, CHAPS (3-[(3-cholamidopropyl)dimethylammonio]-1-propanesulfonate), phosphatidylcholine, miltefosine, lecithin, mristamine oxide, dipalmitoylphosphatidylcholine, hydroxysultaine and sodium lauroamphoacetate.

<Method of inkjet printing>

One aspect of the present invention relates to a method of inkjet printing comprising the following steps:

(1) printing the composition as set out above on a substrate to obtain a printed film;
(2) optionally, dipping the printed film obtained in step (1) in an anti-solvent, to obtained a dipped film; and
(3) annealing the dipped film obtained in step (2).

<Substrate>

The substrate can be selected from the group consisting of metal oxide semiconductors such as ZnO, TiO$_2$, SnO$_2$, Al-doped ZnO (AZO), NiO$_x$, vanadium oxide, SiO$_2$, Al$_2$O$_3$, Si, graphene and other 2D transition metal chalcogenides such as MoS$_2$, MeSe$_2$, FeS$_2$ and VS$_2$, glass coated with fluorine doped tin oxide, glass titanium dioxide surfaces on glass.

<Inkjet printing (1)>

The inkjet-printing step can be realized by using a printing machine appropriate for inkjet-printing.

For example, Dimatix 2831, Dimatix 2850, Ceradrop inkjet printer, commercially available, can be used for inkjet-printing.

<Anti-solvent treatment (2)>

An optional anti-solvent treatment consists in dipping the printed film obtained in step (1) in an anti-solvent.

The anti-solvent can be any organic solvent.

Preferably, the anti-solvent can be selected from the group consisting of benzene, substituted benzenes, such as toluene, fluorobenzene, chlorobenzene, bromobenzene, iodobenzene, toluene, xylene, mesitylene, ethyl acetate, ethyl propionate, methyl propionate, ethyl ether, diethyl ether, propyl ether, butyl ether, pentane, hexane, heptane, cyclohexane, cycloheptane, octane and octene.

Preferably, the anti-solvent is selected from the group consisting of diethyl ether, ethyl acetate, toluene, and hexane.

<Annealing (3)>

In one particular embodiment, anti-solvent treatment step (3) is carried out in an ambient atmosphere, at 120°C, for 30 seconds to 1 minute.

In a preferred embodiment, the method of inkjet-printing further comprises the following step (0) before step (1): (0) spray-depositing a solution comprising $TiO_2$ particles.

<Film processing>

In the film processing, the film is transported from the platen of the inkjet printer to the anti-solvent bath for some time, then placed on a hotplate set to 120 °C.

<Technical effect of the present invention >

By using the composition of the present invention, it is possible to create films of uniform property and thickness, and to assure reproducible fabrication of high quality perovskite films outside of a glovebox and in ambient conditions, as well as stable inkjet-printing at a variety of cartridge and substrate temperatures, from 21°C to 50°C, reducing the "coffee ring" effect upon ink drying/concentration. The present ink composition also has concentration flexibility: perovskite precursors can be dissolved at a variety of concentrations from 0.2 to 1.0 M. Such concentration flexibility facilitates its application in inkjet-printing. The present ink composition is further compatible with anti-solvent treatment.

<Applications>

The present composition can be used in inkjet printing, especially, in order to produce an optoelectronic device, and more specifically, in order to produce a solar cell or a light emitting diode (LED).

In a preferred application, the perovskite-containing composition of the present invention is applied to the surface which has previously been coated with a titanium oxide ($TiO_2$) inkjet composition. This is of particular interest in preparing perovskite solar cell devices, wherein titanium oxide is used as the electron transport material, transporting electrons to the anode.

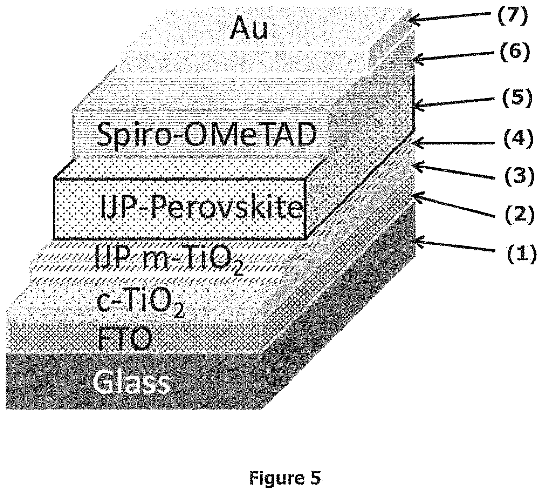

As shown in Figure 5, a solar cell can comprise a substrate layer (in Figure 5, a glass substrate is used), a transparent conducting film layer (in Figure 5, fluorine-doped tin oxide (FTO) is used), an electron extraction layer (in Figure 5, a spray-coated compact $TiO_2$ (c-$TiO_2$) layer is used), an electron transport layer (in Figure 5, an inkjet-printed mesoporous $TiO_2$ (m-$TiO_2$) layer is used), a spin-coated hole transport material (in Figure 5, spiro-OMeTAD is used), and an electrode (in Figure 5, a thermally evaporated Au layer is used).

In advantageous embodiments of the present application, the titanium oxide-containing inkjet printing ink composition is based on a ternary solvent mixture comprising:

(D) a titania source comprising:
(D1) $TiO_2$ particles; and
(E) a solvent mixture comprising:

(E1) a linear alcohol, an alicyclic alcohol, a benzyl alcohol or a mixture thereof;
(E2) poly ethylene glycol, poly propylene glycol, poly(vinyl)alcohol, poly(vinyl)pyrrolidone, ethylcellulose or a mixture thereof; and
(E3) an N,N-dialkylamide, an alkyl sulfoxide or a mixture thereof.

In a preferred embodiment, for the total weight amount of the composition summing to 100% by weight, the weight amount of (D1) is comprised between 0.323 % and 0.418 %:

$$0.323 \leq \frac{weight\ of\ (D1)}{total\ weight\ of\ the\ composition} * 100 \leq 0.418$$

In another preferred embodiment, for the total amount of added (E1), (E2) and (E3) summing to 100% by volume, the amount of (E1) is 58% by volume or more and 68% by volume or less, the amount of (E2) is 16% by volume or more and 26% by volume or less, and the amount of (E3) is 11% by volume or more and 21% by volume or less:

$$58 \leq \frac{volume\ of\ (E1)}{sum\ of\ the\ volume\ of\ (E1),(E2)\ and\ (E3)} * 100 \leq 68$$

$$16 \leq \frac{volume\ of\ (E2)}{sum\ of\ the\ volume\ of\ (E1),(E2)\ and\ (E3)} * 100 \leq 26$$

$$11 \leq \frac{volume\ of\ (E3)}{sum\ of\ the\ volume\ of\ (E1),(E2)\ and\ (E3)} * 100 \leq 21$$

preferably, the amount of (E1) is 61% by volume or more and 65% by volume or less, the amount of (E2) is 19% by volume or more and 23% by volume or less, and the amount of (E3) is 14% by volume or more and 18% by volume or less:

$$61 \leq \frac{(E1)}{sum\ othe\ volume\ of\ (E1),(E2)\ and\ (E3)} * 100 \leq 65$$

$$19 \leq \frac{(E2)}{sum\ of\ the\ volume\ of\ (E1),(E2)\ and\ (E3)} * 100 \leq 23$$

$$14 \leq \frac{(E3)}{sum\ of\ the\ volume\ of\ (E1),(E2)\ and\ (E3)} * 100 \leq 18$$

A preferred specific example of $TiO_2$ ink formulation is a ternary solvent blend with proportions of 60% cyclohexanol, 20% PEG-400, 15% DMF, 2.1% $TiO_2$ paste (19.0% by weight of $TiO_2$ having a diameter of around 30 nm, dissolved in solvents), 2.1% titanium bis(acetylacetonate)diisopropoxide solution (75% by weight solution in isopropanol), 0.8% dispersant (non-ionic surfactants such as tween-60).

The $TiO_2$ ink was particularly effective when the concentration of $TiO_2$ paste was between 1.7% and 2.2%, with 2.1% being the observed optimal concentration. Additionally, the presence of the TAA (Titanium diisopropoxide bis(acetylacetonate)) additive helps in ensuring adequate surface coverage across the film, and two different size regimes of nanoparticles: 5 nm and 30 nm.

Examples

**1) Ink Synthesis:**

**1)-1: Preparation of perovskite ink**

The following starting materials were mixed to prepare an ink composition:

0.417 mL gamma-butyrolactone;
0.062 mL N-methylpyrrolidone;
0.352 mL dimethyl sulfoxide;
0.417 mL N,N'-dimethylformamide;
with $PbI_2$ (1.15 mmol, 0.53 g), FAI (1.033 mmol, 0.177 g), $PbBr_2$ (0.19 mmol, 0.071 g), MABr (0.18 mmol, 0.020 g), CsI (0.115 mmoln 0.02988 g), GuI (0.063 mmol, 0.012 g), and phosphatidylcholine (0.001 g)

The solvents are added to the dry powder chemicals in each case.

The obtained ink composition comprised 0.9 M of Pb precursors.

The solvent in the anti-solvent bath is diethyl ether, and the film is wet after printing and dry after the bath and before heat treatment.

A high performance ink was obtained with 0.6 M $PbI_2$, 0.6 M methylammonium iodide, and 0.2 M methylammonium chloride in the previously mentioned solvent blend.

## 1)-2: Preparation of $TiO_2$ ink

PEG-400 (0.20 mL), cyclohexanol (0.65 mL), N,N-dimethylformamide (0.15 mL), and TWEEN-60 (0.008 g) and GreatCell Solar Italia-NRT 30 $TiO_2$ paste (0.028 g), comprising 19% by weight (i.e. 0.00532 g) of $TiO_2$ particles, were mixed, sonicated, and stirred at room temperature until thoroughly mixed. The suspension was then filtered with a 1.2 $\mu$m filter.

A $TiO_2$ ink formulation was prepared as a ternary solvent blend with proportions of 60% cyclohexanol, 20% PEG-400, 15% DMF, 2.1% $TiO_2$ paste, 2.1% titanium bis(acetylacetonate) diisopropoxide solution, 0.8% dispersant.

## 2) Device fabrication

## 2)-1: Substrate Preparation before printing $TiO_2$

Electrode preparation with compact $TiO_2$: Chemically etched FTO glass (Nippon Sheet Glass) was sequentially cleaned by sonication in a 2 % Helmanex solution, deionized water, acetone and isopropanol for 8 min each. To form a 30 nm thick $TiO_2$ blocking layer, titanium di-isopropoxide bis(acetylacetonate) (TAA, 75% in isopropanol) solution (Sigma-Aldrich) diluted in ethanol 3% (v/v) was deposited by spray pyrolysis at 450 °C.

## 2)-2: Inkjet printing of mesoporous $TiO_2$

The $TiO_2$ ink was added to a disposable Dimatix (DMP-2800) 1.5 mL printer cartridge of nominally 10 pL jetted droplet volume and containing 16 nozzles (21 $\mu$m orifice) and nozzle spacing of 254 $\mu$m. The cartridge head was warmed to 70°C and the substrate was warmed to 35°C. After printing, the substrate was warmed to 100°C for 10 min and then baked at 500°C for 30 min. The annealed substrates were then scored with glass scorer/cutter to yield 1.35 x 2.35 cm$^2$ areas.

The ink was printed on a thin layer of titanium dioxide which was deposited on fluorine-doped tin oxide deposited on a glass substrate.

When fabricating spin-coated perovskite layers on these electrodes, the substrate was broken along the scored lines. When inkjet-printing the perovskite layer on these electrodes, the substrate was not broken along the scored lines until the perovskite was deposited.

## 2)-3: $TiO_2$ film processing

For $TiO_2$ film processing, the printed ink is allowed to dry at room temperature for a period of time of minutes to hours, then annealed on a hot plate up to 500 °C.

Room-temperature drying followed by thermal annealing was then carried out at 500 °C for around 30 min. It is dried before the perovskite ink is added during the thermal annealing step mentioned previously.

## 2)-4 (A): Inkjet-printing of perovskite

The perovskite ink was loaded into a disposable Dimatix (DMP-2800) 1.5 mL printer cartridge of nominally 10 pL jetted droplet volume and containing 16 nozzles (21 $\mu$m orifice) and nozzle spacing of 254 $\mu$m. The cartridge head and substrate were not warmed prior to printing. Once printed, the wet film was immersed in diethylether for 5-10 s, removed, and annealed at 120 °C in ambient conditions.

The ink was used in a Fujifilm Dimatix DMP printer with a 16 nozzle printhead, 21 micron spacing between nozzles at a cartridge temperature of 45 °C. The ink formulation allows for stable printing and reduces coffee ring effect upon ink drying/concentration.

## 2-4 (B): Perovskite Deposition by spin-coating (Comparative Example)

Mixed-perovskite precursor was prepared by mixing 1.15 M $PbI_2$, 1.10 M FAI, 0.2 M $PbBr_2$, 0.2 M MABr in a mixed solvent of DMF:DMSO = 4:1 (volume ratio). Mixed perovskite solutions were successively spin-coated in the glovebox as follows: first, 2000 rpm for 10 s with a ramp-up of 200 rpm·s$^{-1}$; second, 6000 rpm for 30 s with a ramp-up of 2000 rpm·s$^{-1}$. Toluene (110 µl) was dropped on the spinning substrate during the second spin-coating step 20 s before the end of the procedure. Then films were annealed at 100 °C for 90 min.

The pure MaPbI$_3$ precursor solution contained 1.3 M PbI$_2$ and 1.3 M MAI in anhydrous DMSO. The perovskite films were prepared by spin-coating on the substrates at 1000 rpm for the first 10 s and 4000 rpm for the following 30 s. Chlorobenzene (0.1 mL, CB) was slowly dropped on the film 10 s before the spin-coating program finished, then the samples were heated at 100°C for 1 hour.

**2)-5: Perovskite film processing**

For perovskite film processing, the wet ink is submerged in an anti-solvent bath for a period of time of seconds to minutes and then the dry film is annealed on a hot plate at 120 °C.

After printing the perovskite precursor ink, the films were dipped in anti-solvent bath of diethyl ether, then dried, and annealed in ambient atmosphere at 120 °C for 30s -1 min.

**2)-6: Hole Transport Material (HTM) Deposition and gold evaporation**

HTM solution (40 µL) containing 91 mg Spiro-OMeTAD and additives (21 µL of Li-bis(trifluoromethanesulfonyl)imide from a stock solution of 520 mg in 1 mL of acetonitrile, 16 µL of FK209, tris(2-(1H-pyrazol-1-yl)-4-tert-3 butylpyridine)-cobalt(III) tris(bis(trifluoromethylsulfonyl)imide from a stock solution of 375 mg in 1 mL of acetonitrile, and 36 µL of 4-tertbutylpyridine in 1 mL of CB was spin-coated on the samples at 4000 rpm for 20 s, and followed by the evaporating Au electrode with thickness of 70 nm.

**Photovoltaic Characterization**

The photovoltaic performance was analyzed using a VeraSol LED solar simulator (Newport) coupled with a Keithley 2400 source/meter giving light with AM 1.5G (100 W/cm$^2$) spectral distribution. A black mask with an aperture 0.16 cm$^2$ was applied on top of the cell. The light intensity was calibrated with an NREL certified KG5 filtered Si reference diode.

Table 1 presents photovoltaic performance of perovskite solar cells utilizing inkjet-printed mesoporous TiO$_2$ layers under 100 mW·cm$^{-2}$ simulated solar irradiation. Each value is an average of measurements from at least three devices.

Table 1

| Drop Spacing [dpi] (µm) | $J_{SC}$ (mA·cm$^{-2}$) | $V_{OC}$ (mV) | FF (%) | PCE (%) |
|---|---|---|---|---|
| 25 [1270] | 18.32 | 753 | 53.1 | 4.64 |
| 29 [876] | 13.16 | 807 | 57.5 | 6.14 |
| 30 [897] | 18.62 | 768 | 47.5 | 7.07 |
| 31 [819] | 15.26 | 951 | 66.7 | 9.33 |
| 35 [726] | 16.19 | 1007 | 68.2 | 12.15 |

**Claims**

1. Composition comprising:

    (A) at least one perovskite precursor(s); and
    (B) a mixture of solvents comprising:

        (B1) a lactone, an ester or a carbonate;
        (B2) a linear N,N-dialkylamide;
        (B3) a lactam;
        (B4) an alkyl sulfoxide,

wherein the added volumes of solvents (B1), (B2) and (B3) satisfy the relation: (B3) < (B4), (B4) < (B1) and (B4) < (B2).

2. Composition according to claim 1, wherein lactam (B3) is selected from the group consisting of N-alkyl lactams, and more preferably is N-methylpyrrolidone.

3. Composition according to claim 1 or 2, wherein the at least one perovskite precursor(s) (A) is (are) selected from the group consisting of: MAI, $PbI_2$, MABr, $PbBr_2$, MACl, $PbCl_2$, PEAI, PEABr, PEACl, CsI, $SrCl_2$, $CaCl_2$, KI, CsBr, CsCl, NaCl, NaI, GUAI, GUABr, GUACl, FAI, FABr, FACl wherein MA stands for methylammonium, PEA for phenylethylammonium, GUA for guanidinium, and FA for formamidinium, and the perovskite precursor(s) is (are) preferably selected from $Pb^{2+}$, methyammonium, formamidium, guanidinium, cesium, iodide bromide, chloride, acetate and thiocyanate ions, and most preferably, the perovskite precursors (A) are $PbI_2$, methylammonium iodide and/or methylammonium chloride.

4. Composition according to any one of claims 1 to 3, wherein lactone (B1) is selected from the group consisting of gamma-butyrolactones optionally having one or more C1-C4 alkyl substituents on the carbon atoms of the lactone ring, and preferably is non-substituted gamma-butyrolactone.

5. Composition according to any one of claims 1 to 4, wherein linear N,N-dialkylamide (B2) is selected from the group consisting of N,N-dimethylformamide (DMF), N,N-diethylformamide (DEF), N,N-dimethylacetamide (DMAC) and N,N-diethylacetamide (DEAC), and preferably is N,N-dimethylformamide (DMF).

6. Composition according to any one of claims 1 to 5, wherein alkyl sulfoxide (B4) is selected from the group consisting of dimethyl sulfoxide, ethylmethyl sulfoxide and diethyl sulfoxide, and more preferably (B4) is dimethylsulfoxide.

7. Composition according to any of claims 1 to 6, wherein lactone (B1) is unsubstituted gamma-butyrolactone, linear N,N-dialkylamide (B2) is N,N-dimethylformamide and lactam (B3) is N-methylpyrrolidone.

8. Composition according to any of claims 1 to 7, wherein the combined concentration of all the perovskite precursors is 0.2 M or more and 0.4 M or less.

9. Composition according to any of claims 1 to 8, wherein, for a total amount of added volume of solvents (B1), (B2), (B3) and (B4) summing to 100% by volume, the amount of (B1) is 30% by volume or more and 40% by volume or less, the amount of (B2) is 30% by volume or more and 40% by volume or less, the amount of (B3) is 0.01% by volume or more and 10% by volume or less and the amount of (B4) is 26% by volume or more and 30% by volume or less:

$$30 \leq \frac{volume\ of\ (B1)}{sum\ of\ the\ volume\ of\ (B1), (B2), (B3)\ and\ (B4)} * 100 \leq 40$$

$$30 \leq \frac{volume\ of\ (B2)}{sum\ of\ the\ volume\ of\ (B1), (B2), (B3)\ and\ (B4)} * 100 \leq 40$$

$$0.01 \leq \frac{volume\ of\ (B3)}{sum\ of\ the\ volume\ of\ (B1), (B2), (B3)\ and\ (B4)} * 100 \leq 10$$

$$26 \leq \frac{volume\ of\ (B4)}{sum\ of\ the\ volume\ of\ (B1), (B2), (B3)\ and\ (B4)} * 100 \leq 30$$

10. Method of inkjet printing comprising the following steps:

(1) printing the composition according to any one of claims 1 to 9 on a substrate to obtain a printed film;
(2) dipping the printed film obtained in step (1) in an anti-solvent, to obtained a dipped film; and
(3) annealing the dipped film obtained in step (2).

**11.** Method of inkjet-printing according to claim 10, further comprising the following step (0) before step (1):
(0) inkjet-printing a solution comprising $TiO_2$ particles.

**12.** Method according to claim 10 or 11, wherein the substrate is selected from the group consisting of metal-oxide semiconductors such as ZnO, $TiO_2$, $SnO_2$, Al-doped ZnO (AZO), $NiO_x$, vanadium oxide, $SiO_2$, $Al_2O_3$, Si, graphene and other 2D transition metal chalcogenides, glass coated with fluorine doped tin oxide, glass titanium dioxide surfaces on glass.

**13.** Method according to any one of claims 10 to 12, wherein the anti-solvent is selected from the group consisting of benzene, substituted benzenes, such as toluene, fluorobenzene, chlorobenzene, bromobenzene, iodobenzene, toluene, xylene, mesitylene, ethyl acetate, ethyl propionate, metyl propionate, ethyl ether, diethyl ether, propyl ether, butyl ether, pentane, hexane, heptane, cyclohexane, cycloheptane, octane and octene.

**14.** Method according to any one of claims 10 to 13, wherein step (3) is carried out in an ambient atmosphere, at 150°C, for 1 to 3 minutes.

**15.** Use of the composition according to any one of claims 1 to 9 in inkjet printing.

**16.** Use according to claim 15, in order to produce an optoelectronic device.

**17.** Use according to claim 15 or 16, in order to produce a solar cell or a light emitting diode (LED).

**18.** A solar cell wherein the composition according to any one of claims 1 to 9 and a composition comprising perovskite precursors are inkjet-printed.

**19.** A solar cell according to claim 18, comprising, in the following order:

- a glass substrate (1);
- a coating layer (2) of fluorine-doped tin oxide or indium doped tin oxide;
- a thin layer of spray-coated $TiO_2$ layer (3);
- an inkjet-printed $TiO_2$ layer (4);
- an inkjet-printed perovskite layer of the composition according to any one of claims 1 to 9 (5);
- a spin-coated hole transport material layer (6); and
- a thermally evaporated gold layer (7).


**Patentansprüche**

**1.** Zusammensetzung, umfassend:

(A) mindestens eine Perowskit-Vorstufe(n); und
(B) ein Gemisch aus Lösungsmitteln, umfassend:

(B1) ein Lacton, einen Ester oder ein Carbonat;
(B2) ein lineares N,N-Dialkylamid;
(B3) ein Lactam;
(B4) ein Alkylsulfoxid,

wobei die zugegebenen Volumen der Lösungsmittel (B1), (B2) und (B3) die folgende Beziehung erfüllen: (B3) < (B4), (B4) < (B1) und (B4) < (B2).

**2.** Zusammensetzung nach Anspruch 1, wobei das Lactam (B3) ausgewählt ist aus der Gruppe bestehend aus N-Alkyllactamen und noch bevorzugter N-Methylpyrrolidon ist.

**3.** Zusammensetzung nach Anspruch 1 oder 2, wobei die mindestens eine Perowskit-Vorstufe(n) (A) ausgewählt ist (sind) aus der Gruppe bestehend aus: MAI, $PbI_2$, MABr, $PbBr_2$, MACl, $PbCl_2$, PEAI, PEABr, PEACl, CsI, $SrCl_2$, $CaCl_2$, KI, CsBr, CsCl, NaCl, NaI, GUAI, GUABr, GUACl, FAI, FABr, FACl, wobei MA für Methylammonium steht, PEA für Phenylethylammonium, GUA für Guanidin und FA für Formamidin steht, und die Perowskit-Vorstufe(n) bevorzugt ausgewählt ist (sind) aus $Pb^{2+}$-, Methylammonium-, Formamidin-, Guanidin-, Cäsium-, Iodid-, Bromid-, Chlorid-, Acetat- und Thiocyanat-Ionen und die Perowskit-Vorstufen (A) am bevorzugtesten $PbI_2$, Methylammoniumiodid und/oder Methylammoniumchlorid sind.

4. Zusammensetzung nach einem der Ansprüche 1 bis 3, wobei das Lacton (B1) ausgewählt ist aus der Gruppe bestehend aus Gamma-Butyrolactonen, die gegebenenfalls einen oder mehrere C1-C4-Alkyl-Substituenten an den Kohlenstoffatomen des Lactonrings aufweisen, und bevorzugt nicht substituiertes Gamma-Butyrolacton ist.

5. Zusammensetzung nach einem der Ansprüche 1 bis 4, wobei das lineare N,N-Dialkylamid (B2) ausgewählt ist aus der Gruppe bestehend aus N,N-Dimethylformamid (DMF), N,N-Diethylformamid (DEF), N,N-Dimethylacetamid (DMAC) und N,N-Diethylacetamid (DEAC) und bevorzugt N,N-Dimethylformamid (DMF) ist.

6. Zusammensetzung nach einem der Ansprüche 1 bis 5, wobei das Alkylsulfoxid (B4) ausgewählt ist aus der Gruppe bestehend aus Dimethylsulfoxid, Ethylmethylsulfoxid und Diethylsulfoxid und (B4) noch bevorzugter Dimethylsulfoxid ist.

7. Zusammensetzung nach einem der Ansprüche 1 bis 6, wobei das Lacton (B1) nicht substituiertes Gamma-Butyrolacton ist, das lineare N,N-Dialkylamid (B2) N,N-Dimethylformamid ist und das Lactam (B3) N-Methylpyrrolidon ist.

8. Zusammensetzung nach einem der Ansprüche 1 bis 7, wobei die kombinierte Konzentration sämtlicher Perowskit-Vorstufen 0,2 M oder mehr und 0,4 M oder weniger beträgt.

9. Zusammensetzung nach einem der Ansprüche 1 bis 8, wobei bezogen auf eine Gesamtmenge an zugegebenem Volumen der Lösungsmittel (B1), (B2), (B3) und (B4), die sich auf 100 Volumen-% beläuft, die Menge an (B1) 30 Volumen-% oder mehr und 40 Volumen-% oder weniger beträgt, die Menge an (B2) 30 Volumen-% oder mehr und 40 Volumen-% oder weniger beträgt, die Menge an (B3) 0,01 Volumen-% oder mehr und 10 Volumen-% oder weniger beträgt und die Menge an (B4) 26 Volumen-% oder mehr und 30 Volumen-% oder weniger beträgt:

$$30 \leq \frac{Volumen\ von\ (B1)}{Summe\ des\ Volumens\ von\ (B1), (B2), (B3)\ und (B4)} * 100 \leq 40$$

$$30 \leq \frac{Volumen\ von\ (B2)}{Summe\ des\ Volumens\ von\ (B1), (B2), (B3)\ und (B4)} * 100 \leq 40$$

$$0,01 \leq \frac{Volumen\ von\ (B3)}{Summe\ des\ Volumens\ von\ (B1), (B2), (B3)\ und (B4)} * 100 \leq 10$$

$$26 \leq \frac{Volumen\ von\ (B4)}{Summe\ des\ Volumens\ von\ (B1), (B2), (B3)\ und (B4)} * 100 \leq 30$$

10. Verfahren zum Tintenstrahldrucken, umfassend die folgenden Schritte:

(1) Bedrucken eines Substrats mit der Zusammensetzung nach einem der Ansprüche 1 bis 9, um einen aufgedruckten Film zu erhalten;
(2) Eintauchen des in Schritt (1) erhaltenen aufgedruckten Films in ein Antilösungsmittel, um einen eingetauchten Film zu erhalten; und
(3) Anlassen des in Schritt (2) erhaltenen eingetauchten Films.

11. Verfahren zum Tintenstrahldrucken nach Anspruch 10, ferner umfassend den folgenden Schritt (0) vor Schritt (1):
(0) Tintenstrahldrucken mit einer $TiO_2$-Partikel umfassenden Lösung.

12. Verfahren nach Anspruch 10 oder 11, wobei das Substrat ausgewählt ist aus der Gruppe bestehend aus Metall-Oxid-Halbleitern wie etwa ZnO, $TiO_2$, $SnO_2$, Aldotiertem ZnO (AZO), $NiO_x$, Vanadiumoxid, $SiO_2$, $Al_2O_3$, Si, Graphen; und anderen 2D-Übergangsmetall-Chalkogeniden, mit fluordotiertem Zinnoxid beschichtetem Glas, Glastitandioxidflächen auf Glas.

13. Verfahren nach einem der Ansprüche 10 bis 12, wobei das Antilösungsmittel ausgewählt ist aus der Gruppe bestehend aus Benzol, substituierten Benzolen, wie etwa Toluol, Fluorbenzol, Chlorbenzol, Brombenzol, lodbenzol, Toluol, Xylol, Mesitylen, Ethylacetat, Ethylpropionat, Methylpropionat, Ethylether, Diethylether, Propylether, Butylether, Pentan, Hexan, Heptan, Cyclohexan, Cycloheptan, Octan und Octen.

14. Verfahren nach einem der Ansprüche 10 bis 13, wobei Schritt (3) in einer Umgebungsatmosphäre bei 150 °C für 1 bis 3 Minuten ausgeführt wird.

15. Verwendung der Zusammensetzung nach einem der Ansprüche 1 bis 9 beim Tintenstrahldrucken.

16. Verwendung nach Anspruch 15, um eine optoelektronische Vorrichtung herzustellen.

17. Verwendung nach Anspruch 15 oder 16, um eine Solarzelle oder eine Leuchtdiode (LED) herzustellen.

18. Solarzelle, wobei die Zusammensetzung nach einem der Ansprüche 1 bis 9 und eine Perowskit-Vorstufen umfassende Zusammensetzung per Tintenstrahldruck aufgebracht werden.

19. Solarzelle nach Anspruch 18, umfassend, in der folgenden Reihenfolge:

ein Glassubstrat (1);
eine Beschichtungsschicht (2) aus fluordotiertem Zinnoxid oder indiumdotiertem Zinnoxid;
eine dünne Schicht einer aufgesprühten $TiO_2$-Schicht (3);
eine per Tintenstrahldruck aufgebrachte $TiO_2$-Schicht (4);
eine per Tintenstrahldruck aufgebrachte Perowskit-Schicht der Zusammensetzung nach einem der Ansprüche 1 bis 9 (5);
eine per Rotationsbeschichtung aufgebrachte Lochtransportmaterialschicht (6); und
eine thermisch aufgedampfte Goldschicht (7).


## Revendications

1. Composition comprenant :

(A) au moins un précurseur(s) de pérovskite ; et
(B) un mélange de solvants comprenant :

(B1) une lactone, un ester ou un carbonate ;
(B2) un N,N-dialkylamide linéaire ;
(B3) un lactame ;
(B4) un alkylsulfoxyde,

dans laquelle les volumes ajoutés de solvants (B1), (B2) et (B3) satisfont la relation : (B3) < (B4), (B4) < (B1) et (B4) < (B2).

2. Composition selon la revendication 1, dans laquelle le lactame (B3) est choisi dans le groupe consistant en N-alkyl lactames, et est encore mieux la N-méthylpyrrolidone.

3. Composition selon la revendication 1 ou 2, dans laquelle le au moins un précurseur(s) de pérovskite (A) est(sont) choisi(s) dans le groupe consistant en : MAI, $PbI_2$, MABr, $PbBr_2$, MACl, $PbCl_2$, PEAI, PEABr, PEACl, CsI, $SrCl_2$, $CaCl_2$, KI, CsBr, CsCl, NaCl, NaI, GUAI, GUABr, GUACl, FAI, FABr, FACl dans laquelle MA représente le méthylammonium, PEA le phényléthylammonium, GUA le guanidinium, et FA le formamidinium, et le(s) précurseur(s) de pérovskite est(sont) de préférence choisi(s) parmi $Pb^{2+}$, méthylammonium, formamidium, guanidinium, césium, iodure, bromure, chlorure, acétate et ions thiocyanate, et encore mieux, les précurseurs de pérovskite (A) sont $PbI_2$, iodure de méthylammonium et/ou chlorure de méthylammonium.

4. Composition selon l'une quelconque des revendications 1 à 3, dans laquelle la lactone (B1) est choisie dans le groupe consistant en gamma-butyrolactones présentant éventuellement un ou plusieurs substituants alkyle en C1-C4 sur les atomes de carbone du noyau lactone, et est de préférence de la gamma-butyrolactone non-substituée.

5. Composition selon l'une quelconque des revendications 1 à 4, dans laquelle le N,N-dialkylamide linéaire (B2) est choisi dans le groupe consistant en N,N-diméthylformamide (DMF), N,N-diéthylformamide (DEF), N,N-diméthylacétamide (DAMC) et N,N-diéthylacétamide (DEAC), et est de préférence le N,N-diméthylformamide (DMF).

6. Composition selon l'une quelconque des revendications 1 à 5, dans laquelle l'alkylsulfoxyde (B4) est choisi dans le groupe consistant en diméthylsulfoxyde, éthylméthylsulfoxyde et diéthylsulfoxyde, et encore mieux (B4) est le diméthylsulfoxyde.

7. Composition selon l'une quelconque des revendications 1 à 6, dans laquelle la lactone (B1) est la gamma-butyrolactone non-substituée, le N,N-dialkylamide linéaire (B2) est le N,N-diméthylformamide et le lactame (B3) est la N-méthylpyrrolidone.

8. Composition selon l'une quelconque des revendications 1 à 7, dans laquelle la concentration combinée de tous les précurseurs de pérovskite est de 0,2 M ou supérieure et 0,4 M ou inférieure.

9. Composition selon l'une quelconque des revendications 1 à 8, dans laquelle, pour une quantité totale de volumes ajoutés des solvants (B1), (B2), (B3) et (B4) pour un total de 100 % en volume, la quantité de (B1) est de 30 % en volume ou plus et 40 % en volume ou moins, la quantité de (B2) est de 30 % en volume ou plus et 40 % en volume ou moins, la quantité de (B3) est de 0,01 % en volume ou plus et 10 % en volume ou moins et la quantité de (B4) est de 26 % en volume ou plus et 30 % en volume ou moins :

$$30 \leq \frac{volume\ de\ (B1)}{somme\ du\ volume\ de\ (B1),(B2),(B3)\ et\ (B4)} * 100 \leq 40$$

$$30 \leq \frac{volume\ de\ (B2)}{somme\ du\ volume\ de\ (B1),(B2),(B3)\ et\ (B4)} * 100 \leq 40$$

$$0,01 \leq \frac{volume\ de\ (B3)}{somme\ du\ volume\ de\ (B1),(B2),(B3)\ et\ (B4)} * 100 \leq 10$$

$$26 \leq \frac{volume\ de\ (B4)}{somme\ du\ volume\ de\ (B1),(B2),(B3)\ et\ (B4)} * 100 \leq 30$$

10. Procédé d'impression par jet d'encre comprenant les étapes suivantes :

    (1) impression de la composition selon l'une quelconque des revendications 1 à 9 sur un substrat pour obtenir un film imprimé ;
    (2) immersion du film imprimé obtenu dans l'étape (1) dans un anti-solvant, pour obtenir un film immergé ; et
    (3) recuit du film immergé obtenu dans l'étape (2).

11. Procédé d'impression par jet d'encre selon la revendication 10, comprenant de plus l'étape (0) suivante avant l'étape (1) :
    (0) impression par jet d'encre d'une solution comprenant des particules de $TiO_2$.

12. Procédé selon la revendication 10 ou 11, dans lequel le substrat est choisi dans le groupe consistant en semi-conducteurs d'oxyde de métal tel que ZnO, $TiO_2$, $SnO_2$, ZnO dopé par Al (AZO), $NiO_x$, oxyde de vanadium, $SiO_2$, $Al_2O_3$, Si, graphène et d'autres chalcogénures de métal de transition 2D, verre revêtu avec de l'oxyde d'étain dopé au fluor, verre avec surfaces de dioxyde de titane sur verre.

13. Procédé selon l'une quelconque des revendications 10 à 12, dans lequel l'anti-solvant est choisi dans le groupe consistant en benzène, benzènes substitués, tels que toluène, fluorobenzène, chlorobenzène, bromobenzène, iodobenzène, toluène, xylène, mésitylène, acétate d'éthyle, propionate d'éthyle, propionate de méthyle, éthyléther, diéthyléther, propyléther, butyléther, pentane, hexane, heptane, cyclohexane, cycloheptane, octane et octène.

**14.** Procédé selon l'une quelconque des revendications 10 à 13, dans lequel l'étape (3) est réalisée dans une atmosphère ambiante, à 150°C, pendant de 1 à 3 minutes.

**15.** Utilisation de la composition selon l'une quelconque des revendications 1 à 9 dans une impression par jet d'encre.

**16.** Utilisation selon la revendication 15, afin de produire un dispositif optoélectronique.

**17.** Utilisation selon la revendication 15 ou 16, afin de produire une cellule solaire ou une diode électroluminescente (LED).

**18.** Cellule solaire dans laquelle la composition selon l'une quelconque des revendications 1 à 9 et une composition comprenant des précurseurs de pérovskite sont imprimées par jet d'encre.

**19.** Cellule solaire selon la revendication 18, comprenant, dans l'ordre suivant :

- un substrat en verre (1) ;
- une couche de revêtement (2) d'oxyde d'étain dopé au fluor ou d'oxyde d'étain dopé à l'indium ;
- une mince couche de couche de $TiO_2$ déposée par pulvérisation (3) ;
- une couche de $TiO_2$ imprimée par jet d'encre (4) ;
- une couche de pérovskite imprimée par jet d'encre de la composition selon l'une quelconque des revendications 1 à 9 (5) ;
- une couche de matière de transport de trou déposée par centrifugation (6) ; et
- une couche d'or thermiquement évaporé (7).

**Figure 1**

a)

b)

**Figure 2**

Figure 3

a)

Voc: 1.028 V
Jsc: 19.35 mAcm$^{-2}$
FF: 71.0 %
PCE: 14.11 %

b)

Backwards:
Voc: 1.020 V
Jsc: 19.24 mAcm$^{-2}$
FF: 70.0 %
PCE: 13.73 %

Forward:
Voc: 1.004 V
Jsc: 19.19 mAcm$^{-2}$
FF: 57.5 %
PCE: 11.08 %

Figure 4

Au (7)
(6)
(5)
Spiro-OMeTAD (4)
(3)
IJP-Perovskite (2)
IJP m-TiO$_2$ (1)
c-TiO$_2$
FTO
Glass

Figure 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3223323 A
- WO 2017158551 A
- US 20180105543 A
- EP 3279960 A
- TW 201709540

**Non-patent literature cited in the description**

- *J. Mater. Chem. A.,* 2016, vol. 4, 19207
- *Phys. Status Solidi A,* vol. 214, 1700509
- *J. Mater. Chem. A.,* 2015, vol. 3 (17), 9092
- *ACSAppl. Energy Mater.,* 2018, vol. 1 (5), 1834-1839
- **HABIBI et al.** *Renewable and Sustainable Energy Reviews,* 2016, vol. 62, 1012-1031